(19) Europäisches Patentamt

European Patent Office

Office européen des brevets

(11) **EP 0 529 129 B1**

(12) **EUROPÄISCHE PATENTSCHRIFT**

(45) Veröffentlichungstag und Bekanntmachung des Hinweises auf die Patenterteilung:
**04.11.1998  Patentblatt 1998/45**

(51) Int Cl.⁶: **H04N 5/205**

(21) Anmeldenummer: **91114523.3**

(22) Anmeldetag: **29.08.1991**

(54) **Begrenzerschaltung**

Limiter circuit

Circuit limiteur

(84) Benannte Vertragsstaaten:
**DE FR NL**

(43) Veröffentlichungstag der Anmeldung:
**03.03.1993  Patentblatt 1993/09**

(73) Patentinhaber: **Micronas Intermetall GmbH
79108 Freiburg (DE)**

(72) Erfinder:
• **Desor, Hans-Jürgen, Dipl.-Ing.
W-7803 Gundelfingen (DE)**
• **Koehne, Heinrich, Dipl.-Ing.
W-7801 Vörstetten (DE)**

(56) Entgegenhaltungen:
EP-A- 0 157 460          GB-A- 2 157 909
US-A- 3 529 244          US-A- 4 064 537

**Beschreibung**

Die Erfindung betrifft eine Begrenzerschaltung und ein Verfahren zur Begrenzung von Video-Signalen. Begrenzerschaltungen werden eingesetzt, wenn der Pegelumfang eines elektrischen Signals zu groß ist, so daß er von nachfolgenden Verarbeitungsschaltungen nur noch unvollständig erfaßt werden kann.

Aus US-A 3 529 244 ist eine Begrenzerschaltung für ein FM-Übertragungssystem bekannt. Mittels eines Hoch- und eines Tiefpasses wird das zu modulierende Signal in zwei Frequenzbereiche aufgeteilt, die jeweils unterschiedlich verarbeitet und wieder zusammengeführt werden. Der Hochpaßzweig enthält einen Equalizer, der die vorgegebene Preemphasis bewirkt und zur Begrenzung eine linear arbeitende automatische Verstärkungsregelstufe (AGC) enthält. Der Tiefpaßzweig enthält ebenfalls zur Begrenzung eine lineare automatische Verstärkungsregelstufe (AGC). Die in den beiden Signalzweigen unterschiedlich modifizierten Signale werden schließlich wieder additiv kombiniert. Verbleibende kurze Amplitudenausreißer werden mittels einer nichtlinearen Begrenzerschaltung vor der weiteren Verarbeitung abgeschnitten. Die gesamte Begrenzerschaltung dient dazu, bei der nachfolgenden FM-Modulation einen FM-Modulationsgrad von möglichst 100 % zu erreichen, jedoch eine Übermodulation zu verhindern.

Begrenzerschaltungen sind auch in Fernsehempfängern erforderlich, insbesondere zur Steuerung des Strahlstroms in der Fernsehbildwiedergaberöhre. Die Ergiebigkeit der einzelnen Strahlsysteme ist nämlich größer als die Farbbildröhre vertragen kann. Die Übersteuerung äußert sich in einem "Ausblühen" von hellen Bildstrukturen und der Bildung von Farbsäumen bei hellen Flächen usw. Für die Übersteuerung der Farbbildröhre sind zwei Grenzwerte maßgebend, die nicht überschritten werden dürfen und die den mittleren Strahlstrom bzw. den Spitzenstrahlstrom betreffen. Für kleine Bilddetails kann nämlich kurzzeitig ein wesentlich größerer Strahlstrom zugelassen werden als beim Strahlstrom-Mittelwert. Bisherige Begrenzerschaltungen in Fernsehempfängern werten über Fühlerschaltungen den Mittelwert und den Kurzzeitwert der Strahlströme aus und regeln die Strahlströme über eine längere oder kürzere Zeitkonstante zurück.

Der Nachteil dieser Begrenzerschaltungen besteht darin, daß sich diese Begrenzung ganz unterschiedlich auf die Signalwiedergabe auswirkt, weil der Signalinhalt selbst bei der Begrenzung nur unwesentlich berücksichtigt wird. Die scharfe Begrenzung führt bei verschiedenen Videofrequenzbereichen zu störenden Signalverfälschungen bei der Bildwiedergabe. Dieser Effekt verstärkt sich, wenn es sich bei den Signalen um digitalisierte Fernsehsignale handelt, die durch Alias- und Faltungseffekte bei der Begrenzung als Störsignale in den eigentlichen Bildbereich transformiert werden.

Aufgabe der in den Ansprüchen gekennzeichneten Erfindung ist es, eine Begrenzerschaltung und ein Verfahren anzugeben, die eine Signalbegrenzung ermöglichen und bei denen die Störsignale in unwichtigen Frequenzbereichen liegen.

Diese Aufgabe wird durch die Gegenstände der Ansprüche 1 und 7 gelöst.

Die Erfindung und weitere Vorteile werden nun anhand der Figuren der Zeichnung näher erläutert:

Fig. 1 zeigt als Blockschaltbild ein vorteilhaftes Ausführungsbeispiel einer Begrenzerschaltung nach der Erfindung und

Fig. 2 zeigt vorteilhafte Ausführungsbeispiele der Filtereinrichtungen gemäß Fig. 1.

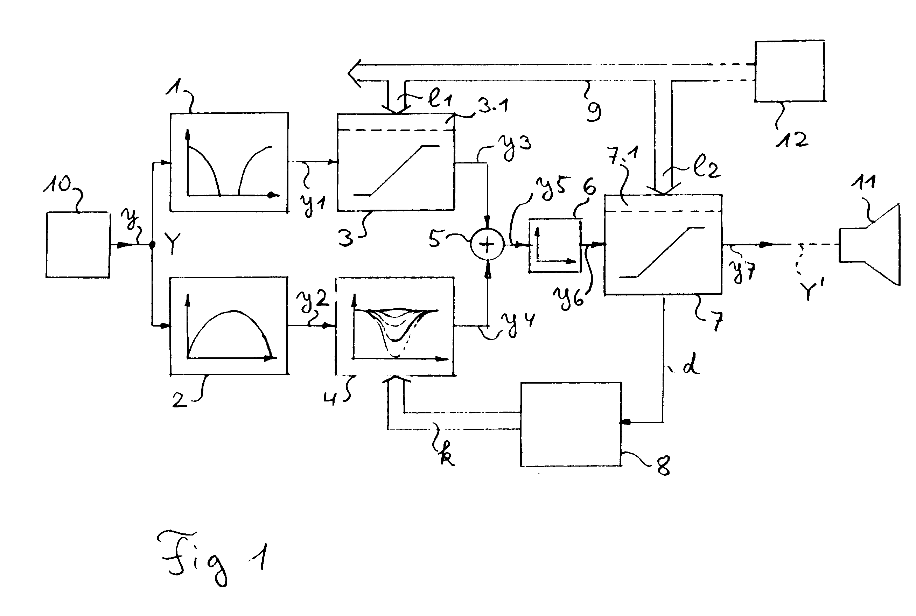

Das bevorzugte Ausführungsbeispiel von Fig. 1 zeigte eine digitale Begrenzerschaltung, der das Eingangssignal y zugeführt ist. Dabei handelt es sich insbesondere um das Helligkeitssignal (= y-Signal) eines digitalen Fernsehempfängers 10, das beispielsweise mit einer Taktfrequenz von 20 MHz digitalisiert ist. Das Signal wird mittels eines Tiefpaß- und eines Hochpaßfilters 1, 2 in zwei Signalbereiche aufgespalten, die als Eingangssignal y1 bzw. y2 einem ersten Begrenzer 3 bzw. einem Kerbfilter 4 zugeführt sind. Der erste Begrenzer weist eine Begrenzungsschwelle 3.1 auf, die dem zulässigen mittleren Strahlstromwert der Bildröhre entspricht. Das Kerbfiilter 4 weist für seinen Kerbfrequenzbereich eine einstellbare Dämpfung auf, wobei die jeweilige Kerbfilterdämpfung durch ein Steuersignal k am Kerbfilter eingestellt wird.

Es wird darauf hingewiesen, daß der erste Begrenzer 3 bei der ersten Begrenzungsschwelle 3.1 das Signal y1 tatsächlich beschneidet, während das Kerbfilter 4 lediglich diejenigen Frequenzkomponenten linear absenkt, die im Bereich der Kerbfrequenz liegen. Eine Signalbeschneidung und damit eine Oberwellenerzeugung bewirkt das Kerbfilter beim Signal y2 nicht.

Das Ausgangssignal y3 bzw. y4 des ersten Begrenzers 3 bzw. des Kerbfilters 4 wird mittels einer Addierschaltung 5 addiert und als Signal y5 dem Eingang eines Kompensationsfilters 6 zugeführt. Dieses Kompensationsfilter 6 ist lediglich dann erforderlich, wenn der Frequenzgang durch die Aufspaltung des ersten und zweiten Filters 1 ,2 nicht ideal ist, so daß eine Zusammenfügung der Signale y1 und y2 zur einer Restwelligkeit führen würde. Durch einen inversen Frequenzgang im Kompensationsfilter 6 wird diese Restwelligkeit beim Signal y6 kompensiert.

In Fig. 1 speist das Ausgangssignal y6 des Kompensationsfilters 6 den Eingang einer zweiten Begrenzerschaltung 7 mit einer Begrenzungsschwelle 7.1, die dem zulässigen Spitzenstrahlstromwert der Bildwiedergaberöhre 11 entspricht. Das Ausgangssignal y7 erfüllt nun alle Begrenzungsanforderungen und entpricht einem modifiziertem Helligkeitssignal (= Y').

Das Ansprechen des zweiten Begrenzers 7 wird durch ein Pegelüberschreitungssignal d einem Regelfilter 8 signalisiert, das beispielsweise als Zählerschaltung ausgebildet ist. Die höchstwertigen Stellen des Zählerinhaltes werden als Steuersignal k abgegriffen und dem digitalen Steuereingang des Kerbfilters 4 zugeführt. Damit ist ein digitaler Amplitudenregelkreis für bestimmte Frequenzen über den zweiten Begrenzer 7 und das Kerbfilter 4 geschlossen. Selbstverständlich kann statt der in Fig. 1 dargestellten Rückwärtsregelung des Kerbfilters 4 auch eine Vorwärtsregelung des Kerbfilters 4 realisiert werden. Das Steuersignal k ist dann in diesem Fall aus einer vorausgehenden Stufe abzuleiten.

Die Erfindung geht von der Erkenntnis aus, daß niedere Videosignalfrequenzen gegenüber einer Beschneidung unkritisch sind. Höhere Videosignalfrequenzen, insbesondere die bei einer Digitalisierung mit einem Digitalisierungstakt von fs = 20 MHz im Bereich von fs/4 liegen, verhalten sich jedoch besonders kritisch gegenüber einer Beschneidung. Daher werden die Videosignalfrequenzen, die in diesem kritischen Frequenzbereich fs/4 liegen durch eine lineare Absenkung in ihrer Amplitude verkleinert. Die Zeitkonstante des Regelfilters 8 umfaßt dabei mindestens ein Halbbild, damit die Begrenzungswirkung für den gesamten Bildeindruck einheitlich ist.

In Fig. 1 ist ferner ein Datenbus 9 dargestellt, der dem ersten und zweiten Begrenzer 3, 7 als Daten den Wert der ersten bzw. zweiten Begrenzungsschwelle 11, 12 aus einem Datenspeicher 12 zuführt.

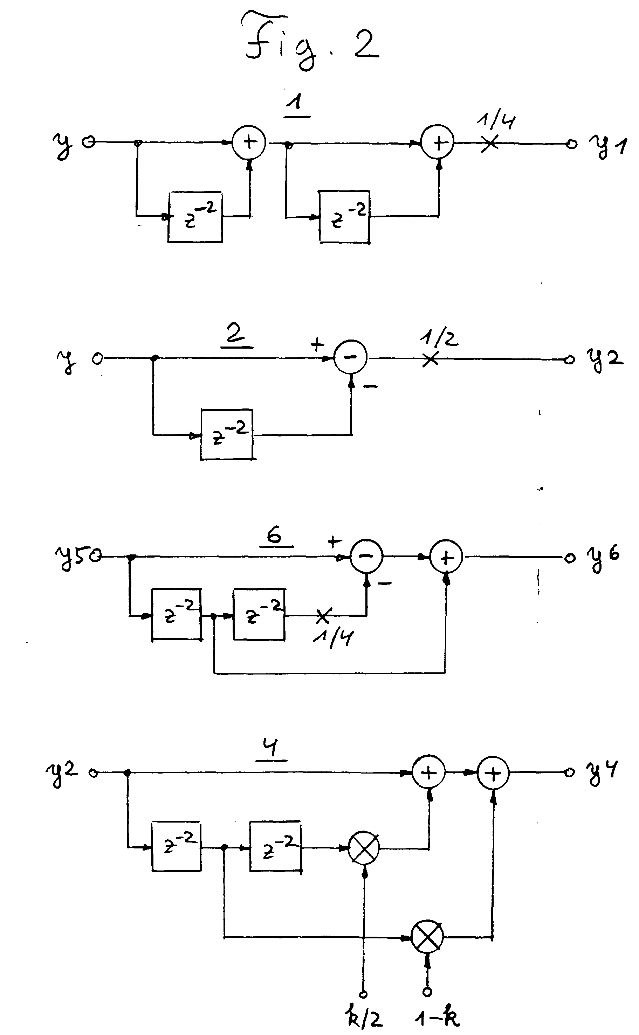

Bei einem Digitalisierungstakt von 20 MHz ergeben sich für die einzelnen Filtern besonders einfache Schaltungsstrukturen, die in Fig. 2 schematisch dargestellt sind.

Das Tiefpaßfilter 1 hat die Übertragungsfunktion

$$H(z) = 1/4 \times (1 + z^{-2})^2,$$

das Hochpaßfilter 2 hat die Übertragungsfunktion

$$H(z) = 1/2 \times (1 - z^{-2}),$$

das Kompensationsfilter 6 hat die Übertragungsfunktion

$$H(z) = 0{,}25 + z^{-2} - 0{,}25 \times z^{-4}$$

und das Kerbfilter 4 hat die Übertragungsfunktion

$$H(z) = k/2 + (1 - k) \times z^{-2} + k/2 \times z^{-4}$$

mit k = 0...0,5.

## Patentansprüche

1. Begrenzerschaltung für ein Videosignal (y), insbesondere für ein an die Bildwiedergaberöhre eines Fernsehempfängers geliefertes Videosignal, z.B. ein Helligkeitssignal, bei dem das Videosignal mittels eines Tiefpaß- und eines Hochpaßfilters (1, 2) auf zwei Signalpfade aufgeteilt ist,

   - an den Ausgang des Tiefpaßfilters (1) ist ein erster Begrenzer (3) angeschlossen, dessen Ausgang am ersten Eingang eines Addierers (5) liegt,

   - an den Ausgang des Hochpaßfilters (2) ist ein Kerbfilter (4) angeschlossen, dessen Dämpfung einstellbar ist und dessen Ausgang mit dem zweiten Eingang des Addierers (5) verbunden ist,

   - der Ausgang des Addierers (5) ist mit dem Eingang eines zweiten Begrenzers (7) gekoppelt, an dessen Signalausgang das ausgangsseitige Videosignal (y7) der Begrenzerschaltung abgreifbar sind, und

   - der zweite Begrenzer (7) erzeugt ein Pegelüberschreitungssignal (d), das zur Signalpegelabsenkung über ein Regelfilter (8) auf den Steuereingang des Kerbfilters (4) zurückgeführt ist.

2. Begrenzerschaltung nach Anspruch 1, dadurch gekennzeichnet, daß eine vom ersten Begrenzer (3) gebildete erste Begrenzungsschwelle (3.1) niedriger ist als eine vom zweiten Begrenzer (7) gebildete zweite Begrenzerschwelle (7.1).

3. Begrenzerschaltung nach Anspruch 1 oder 2, dadurch gekennzeichnet, daß die erste und zweite Begrenzungsschwelle (3.1, 7.1) durch die jeweilige Bildwiedergaberöhre (11) vorgegeben sind.

4. Begrenzerschaltung nach Anspruch 3, in Form einer digitalen Signalverarbeitungsschaltung mit einem digitalisierten Videosignal, dadurch gekennzeichnet, daß Tiefpaß- Hochpaß- und Kerbfilter (1, 2, 4) spiegelsymmetrisch zu einer Frequenz fs /4 sind, die einem Viertel einer Taktfrequenz fs entspricht, welche die Digitalisierungsrate vorgibt.

5. Begrenzerschaltung nach einem der Ansprüche 1 bis 4, dadurch gekennzeichnet, daß zwischen dem Addierer (5) und dem zweiten Begrenzer (7) ein Kompensationsfilter (6) eingefügt ist, das der Einebnung des Frequenzganges dient.

6. Begrenzerschaltung nach Anspruch 4 und 5, gekennzeichnet durch folgende Merkmale:

- das Tiefpaßfilter (1) hat die Übertragungsfunktion:

$$H(z) = 1/4 \times (1 + z^{-2})^2,$$

- das Hochpaßfilter (2) hat die Übertragungsfunktion:

$$H(z) = 1/4 \times (1 - z^{-2}),$$

- das Kerbfilter (4) hat die Übertragungsfunktion:

$$H(z) = k/2 + (1 + k) \times z^{-2} + k/2 \times z^{-4}$$

mit k = 0... 0,5 und

- das Kompensationsfilter (6) hat die Übertragungsfunktion:

$$H(z) = -0,25 + z^{-2} - 0,25 \times z^{-4}.$$

7. Verfahren zur Begrenzung eines Videosignals (y), insbesondere für ein an die Bildwiedergaberöhre eines Fernsehempfängers geliefertes Videosignal, z. B. ein Helligkeitssignal, das folgende Verfahrensschritte aufweist:

- das Videosignal (y) wird mittels eines Tiefpaßfilters (1) und eines Hochpaßfilters (2) aufgespalten,

- das Ausgangssignal des Tiefpaßfilters (1) wird mittels eines ersten Begrenzers (3) auf eine erste Begrenzungsschwelle (3.1) begrenzt,

- das Ausgangssignal des Hochpaßfilters (2) wird über ein Kerbfilter (4) geführt, dessen jeweilige Kerbdämpfung von einem Steuersignal (k) eingestellt wird,

- die Ausgangssignale des ersten Begrenzers (3) und des Kerbfilters (4) werden als Summensignal mittels eines zweiten Begrenzers (7) auf eine zweite Begrenzungsschwelle (7.1) begrenzt und als begrenztes Videosignal ausgegeben, und

- der zweite Begrenzer (7) erzeugt ein Pegelüberschreitungssignal (d), aus dem zur Signalpegelabsenkung mittels eines Regel filters (8) das Steuersignal (k) gebildet wird, das den jeweiligen Kerbdämpfungswert einstellt.

8. Verfahren nach Anspruch 7, dadurch gekennzeichnet, daß die erste und zweite Begrenzungsschwelle (3.1; 7.1 ) durch den Dynamikbereich der Bildwiedergaberöhre (11) vorgegeben sind.

## Claims

1. A limiter circuit for a video signal (y), particularly for a video signal supplied to the picture tube of a television receiver, e.g., a luminance signal, wherein the video signal is divided between two signal paths by means of a low-pass filter (1) and a high-pass filter (2);

- the output of the low-pass filter (1) is connected to a first limiter (3) having its output coupled to the first input of an adder (5);

- the output of the high-pass filter (2) is connected to an adjustable-attenuation notch filter (4) having its output coupled to the second input of the adder (5);

- the output of the adder (5) is coupled to the input of a second limiter (7) which provides at its signal output the video output signal (y7) of the limiter circuit; and

- the second limiter (7) provides a level-transgression signal (d) which is fed back to the control input of the notch filter (4) through a control filter for reducing the signal level.

2. A limiter circuit as claimed in claim 1, characterized in that a first threshold level (3.1) formed by the first limiter (3) is lower than a second threshold level (7.1) formed by the second limiter (7).

3. A limiter circuit as claimed in claim 1 or 2, characterized in that the first and second threshold levels (3.1, 7.1) are predetermined by the respective picture tube (11).

4. A limiter circuit as claimed in claim 3, in the form of a digital signal processing circuit with a digitized video signal, characterized in that the low-pass, high-pass, and notch filters (1, 2, 4) are mirror-symmetrical with respect to a frequency fs/4 equal to one fourth of a clock frequency fs which determines the digitization rate.

5. A limiter circuit as claimed in any one of claims 1 to 4, characterized in that a compensation filter (6) is inserted between the adder (5) and the second limiter (7) for flattening the frequency response.

6. A limiter circuit as claimed in claims 4 and 5, characterized by the following features:

- The low-pass filter (1) has the transfer function

$$H(z) = 1/4 \times (1 + z^{-2})^2;$$

- the high-pass filter (2) has the transfer function

$$H(z) = 1/4 \times (1 - z^{-2});$$

- the notch filter (4) has the transfer function

$$H(z) = k/2 + (1+k) \times z^{-2} + k/2 \times z^{-4},$$

with k = 0...0.5; and

- the compensation filter (6) has the transfer function

$$H(z) = -0.25 + z^{-2} - 0.25 \times z^{-4}.$$

7. A method of limiting a video signal (y), particularly a video signal supplied to the picture tube of a television receiver, e.g., a luminance signal, comprising the following steps:

- The video signal (y) is split up by means of a low-pass filter (1) and a high-pass filter (2);

- the output of the low-pass filter (1) is limited to a first threshold level (3.1) by means of a first limiter (3);

- the output of the high-pass filter (2) is passed through a notch filter (4) whose respective attenuation is adjusted by a control signal (k);

- the outputs of the first limiter (3) and the notch filter (4) are limited as a sum signal to a second threshold level (7.1) by means of a second limiter (7); and

- the second limiter (7) provides a level-transgression signal (d) from which a control filter (8) forms the control signal (k) which adjusts the respective notch attenuation value.

8. A method as claimed in claim 7, characterized in that the first and second threshold levels (3.1; 7.1) are predetermined by the dynamic range of the picture tube (11).

**Revendications**

1. Circuit limiteur pour un signal vidéo (y), en particulier pour un signal vidéo fourni au tube image d'un récepteur de télévision, par exemple un signal de luminance, dans lequel le signal vidéo est partagé sur deux trajets de signal au moyen d'un filtre passe-bas (1) et d'un filtre passe-haut (2) caractérisé par les particularités suivantes :

- à la sortie du filtre passe-bas (1) est relié un premier limiteur (3) dont la sortie est branchée sur une première entrée d'un additionneur (5),
- à la sortie du filtre passe-haut (2) est relié un filtre coupe-bande (4) dont l'amortissement est réglable et dont la sortie est reliée à la deuxième entrée de l'additionneur (5),
- la sortie de l'additionneur (5) est couplée avec l'entrée d'un deuxième limiteur (7) à la sortie de signal duquel on peut prélever le signal vidéo (y7) de sortie du circuit limiteur, et
- le deuxième limiteur (7) produit un signal de dépassement de niveau (d) qui est renvoyé, par l'intermédiaire d'un filtre de régulation (8), sur l'entrée de commande du filtre coupe-bande (4) en vue de la réduction du niveau du signal.

2. Circuit limiteur selon la revendication 1, caractérisé en ce qu'un premier seuil de limitation (3.1) formé par le premier limiteur (3) est plus faible qu'un deuxième seuil de limitation (7.1) formé par le deuxième limiteur (7).

3. Circuit limiteur selon la revendication 1, caractérisé en ce que les premier et deuxième seuils de limitation (3.1, 7.1) sont déterminés par le tube image respectif (11).

4. Circuit limiteur selon la revendication 3, sous la forme d'un circuit de traitement de signaux comportant un signal vidéo numérisé, caractérisé en ce que les filtre passe-bas (1), passe-haut (2) et coupe-bande (4) présentent une symétrie spéculaire par rapport à une fréquence de fs/4 qui correspond à un quart d'une fréquence de battement, fs, qui définit la fréquence de numérisation.

5. Circuit limiteur selon l'une quelconque des revendications 1 à 4, caractérisé en ce que, entre l'additionneur (5) et le deuxième limiteur (7), est introduit un filtre de compensation (6) qui sert au lissage de la réponse en fréquence.

6. Circuit limiteur selon les revendications 4 et 5, caractérisé par les particularités suivantes :

- le filtre passe-bas (1) présente la fonction de transfert suivante :

$$H(z) = 1/4 * (1 + z^{-2})^2,$$

- le filtre passe-haut (2) présente la fonction de transfert suivante :

$$H(z) = 1/4 * (1 - z^{-2}),$$

- le filtre coupe-bande (4) présente la fonction de transfert suivante :

$$H(z) = k/2 + (1 + k) * z^{-2} + k/2 * z^{-4}$$

avec k = 0...0,5 et
- le filtre de compensation (6) présente la fonction de transfert suivante :

$$H(z) = -0,25 + z^{-2} - 0,25 * z^{-4}.$$

7. Procédé pour la limitation d'un signal vidéo (y), en particulier pour un signal vidéo fourni au tube image d'un récepteur de télévision, par exemple un signal de luminance, qui comporte les étapes suivantes :

- le signal vidéo (y) est séparé au moyen d'un filtre passe-bas (1) et d'un filtre passe-haut (2),
- le signal de sortie du filtre passe-bas (1) est limité au moyen d'un premier limiteur (3) à un premier seuil de limitation (3.1),
- le signal de sortie du filtre passe-haut (2) est transmis par l'intermédiaire d'un filtre coupe-bande (4) dont l'amortissement de coupe-bande spécifique est réglé par un signal de commande (k),
- les signaux de sortie du premier limiteur (3) et du filtre coupe-bande (4) sont, en tant que signal somme, limités à un deuxième seuil de limitation (7.1) au moyen d'un deuxième limiteur (7) et délivrés en sortie en tant que signal vidéo limité, et
- le deuxième limiteur (7) produit un signal de dépassement de niveau (d) à partir duquel on forme, pour la réduction du niveau du signal, au moyen d'un filtre de régulation (8), le signal de commande (k) qui règle la valeur d'amortissement respective.

8. Procédé selon la revendication 7, caractérisé en ce que les premier et deuxième seuils de limitation (3.1, 7.1) sont définis par la gamme dynamique du tube image (11).

Fig. 1

Fig. 2